# EUROPÄISCHE PATENTSCHRIFT

(11) **EP 1 269 584 B1**
(45) Veröffentlichungstag und Bekanntmachung des Hinweises auf die Patenterteilung: **31.05.2006**
(21) Anmeldenummer: 01921001.2
(22) Anmeldetag: 30.03.2001
(51) Int. Cl.: H01R 25/16, B60R 16/02, H02G 3/04, H05K 1/14

(54) **KANALFÖRMIGE ANSCHLUSSVORRICHTUNG FÜR ELEKTRISCHE LEITUNGEN VON VERBRENNUNGSMOTOREN**
CHANNEL-SHAPED CONNECTION DEVICE FOR ELECTRICAL LINES OF INTERNAL COMBUSTION ENGINES
DISPOSITIF DE RACCORDEMENT EN FORME DE GOULOTTE DESTINE A DES CABLES ELECTRIQUES DE MOTEURS A COMBUSTION INTERNE

(30) Priorität: 30.03.2000 AT 5412000
(43) Veröffentlichungstag der Anmeldung: 02.01.2003
(73) Patentinhaber: Jenbacher Aktiengesellschaft, 6200 Jenbach/Tirol (AT)
(72) Erfinder: KRAUS, Markus, A-6200 Wiesing (AT); VIRCHOW, Florian, 29223 Celle (DE)
(74) Vertreter: Torggler, Paul Norbert
(86) Internationale Anmeldenummer: PCT/AT2001/000092
(87) Internationale Veröffentlichungsnummer: WO 2001/076020

(56) Entgegenhaltungen:
- EP-B- 0 607 335
- US-A- 4 827 372

## Beschreibung

Die Erfindung bezieht sich auf eine kanalförmige Anschlußvorrichtung für elektrische Leitungen, insbesondere Signal- und Zündleitungen, von Verbrennungsmotoren, gemäß dem Oberbegriff des Anspruches 1.

Zur Versorgung der Steuerelemente eines Verbrennungsmotors ist es bekannt, die elektrischen Leitungen in Form von Kabelbäumen in der Karosserie anzuordnen. Ebenso zählt die Anordnung der Leitungen in Kabelkanälen bereits zum Stand der Technik. Ein derartiger Verteilerkanal wird beispielsweise in der EP 0 607 335 B1 beschrieben. Es hat sich für eine einfache und schnelle Verbindung der zu versorgenden Bauteile mit den elektrischen Leitungen als nachteilig herausgestellt, daß bei den bekannten Vorrichtungen die einzelnen Steckersockel und dergleichen jeweils mit einer im Kabelkanal geführten Leitung verbunden werden müssen.

Aufgabe der Erfindung ist es, eine neuartige Anschlußvorrichtung der eingangs erwähnten Art anzugeben, welche die bekannten Nachteile vermeidet.

Erreicht wird dies erfindungsgemäß die Merkmale des Anspruches 1. Durch die Anordnung der elektrischen Leitungen, die vorteilhafterweise vormontiert sind, und der Bauteile auf einem vorzugsweise einschiebbaren Trägerelement, ist es möglich, die Steckersockel und sonstige Anschlüsse schnell und einfach in der Anschlußvorrichtung zu positionieren.

Im Allgemeinen wird das Trägerelement plattenförrnig ausgebildet sein. Bevorzugterweise kann vorgesehen sein, daß das Trägerelement eine Platine ist, an der die elektrischen Leitungen, die gemäß einem weiteren Aspekt der Erfindung als Leiterbahnen und/oder Kabel ausgebildet sein können, angeordnet sind, wobei es sich als besonders vorteilhaft erwiesen hat, wenn die Anschlußvorrichtung eine Sicke zur Aufnahme zusätzlicher Kabel aufweist. Das Trägerelementweist zumindest teilweise einen modularen Aufbau auf, wobei für eine schnelle und einfache Montage weiters vorgesehen ist daß die einzelnen Module des Trägerelementes elektrisch und mechanisch- vorzugsweise mechanisch lösbar- miteinander verbunden sind. Somit kann in Anpassung an die verschiedensten Ausführungsvarianten und in Abhängigkeit davon, ob jedem Modul des Trägerelementes ein Zylinder des Verbrennungsmotors zugeordnet ist oder jedem Modul des Trägerelementes mehrere, vorzugsweise zwei Zylinder des Verbrennungsmotors zugeordnet sind, ein den jeweiligen Anforderungen entsprechender modularer Platinenzug zusammengesetzt werden, der in weiterer Folge nur mehr in die Anschlußvorrichtung eingebracht, vorzugsweise eingeschoben bzw. eingezogen werden muß. Selbstverständlich ist dieses Funktionsprinzip nicht auf als Platinen ausgebildete modulare Trägerelemente eingeschränkt, sondern bei allen Arten von Trägerelementen, beispielsweise auch bei einem als Alustrang ausgebildeten Trägerelement, anwendbar.

Um den Arbeitsaufwand zum Anschluß der zu versorgenden Steuerelemente des Verbrennungsmotors weiter zu reduzieren, kann günstigerweise vorgesehen sein, daß zumindest ein Teil der Bauteile, die gemäß einer Ausführungsform der Erfindung eine Zündspule und/oder Sensor und/oder Aktormodule - gemäß einem weiteren Aspekt der Erfindung auch die Zündschaltung zur Ansteuerung der Zündspule - umfassen, vor dem Einbringen des Trägerelementes in die Anschlußvorrichtung an diesem unlösbar fixiert ist.

Derselbe Effekt wird erreicht, wenn zumindest ein Teil der Bauteile lösbar am Trägerelement angeordnet ist und zur lösbaren Halterung der Bauteile Steckvorrichtungen vorgesehen sind.
Für diese Ausführungsform der Erfindung ist es günstig, wenn die Anschlußvorrichtung Aufnahmeöffnungen für die lösbar anzuordnenden Bauteile aufweist, und die lösbar anzuordnenden Bauteile durch diese Aufnahmeöffnungen hindurch von außen in die Anschlußvorrichtung einsetzbar und mit dem Trägerelement verbindbar sind, wobei eine bevorzugte Ausführungsvariante vorsieht, daß die Anschlußvorrichtung für jedes Bauteil eine eigene Öffnung aufweist.

Als Material für die Herstellung der Anschlußvorrichtung kann bevorzugterweise Aluminium vorgesehen sein. Es eigenen sich aber auch viele andere Materialien wie beispielsweise Hartkunststoffe oder Eisen, wobei eine weitere Ausführungsform vorsieht, daß die Anschlußvorrichtung zumindest partiell ausgeschäumt ist, beispielsweise mit PU-Schaum.

Weitere Vorteile und Einzelheiten werden anhand der nachfolgenden Zeichnung beschrieben. Darin zeigt
Fig. 1 einen Querschnitt durch ein Ausführungsbeispiel einer erfindungsgemäßen Anschlußvorrichtung,
Fig. 2 eine Draufsicht auf ein modulares Trägerelement,
Fig. 3 einen Schnitt durch Fig. 2 entlang der Linie A,
Fig. 4 ein Ausführungsbeispiel eines modularen Trägerelementes und
Fig. 5 ein weiteres Ausführungsbeispiel an einem Verbrennungsmotor,
Fig. 6 einen schematischen Querschnitt durch eine mehrschichtig ausgebildete Platine als Trägerelement,
Fig. 7 eine elektrische Steckverbindung an der Stirnseite zwischen zwei Modulen eines Trägerelementes,
die Fig. 8 ein alternatives Ausführungsbeispiel zur Fig. 1 im Querschnitt.

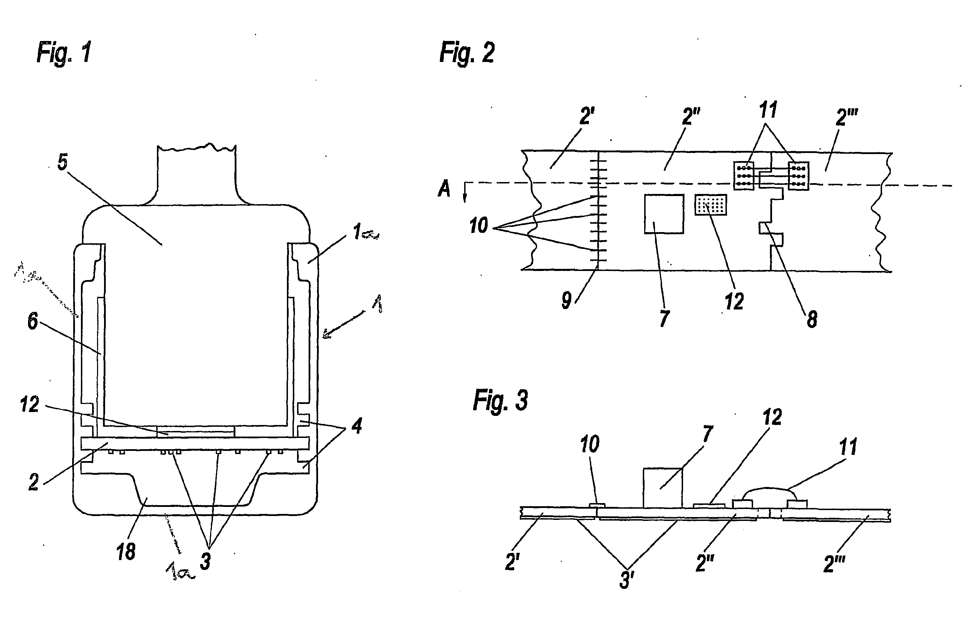

Die in Fig. 1 dargestellte kanalförmige Anschlußvorrichtung 1 weist in der Wand 1a Aufnahmen 4 auf, in die das Trägerelement 2 eingeschoben ist, wobei zur Anpassung an die Größe der Bauteile vorteilhafterweise mehrere von einander beabstandete Aufnahmen 4 vorgesehen sind. An einer Seite des Trägerelementes 2 sind die elektrischen Leitungen 3, vorzugsweise in Form von Leiterbahnen 3', angeordnet. Zur Aufnahme zusätzlicher Kabel weist die Anschlußvorrichtung 1 eine Sicke 18 auf. Auf der anderen Seite des Trägerelementes 2 sind neben der Steckvorrichtung 12, an der bei dieser Ausführungsform der erfindungsgemäßen Anschlußvorrichtung 1 die Zündspule 5 lösbar angeordnet ist, Meßmodule 6, welche bereits vor dem Einbringen des Trägerelementes 2 in die Anschlußvorrichtung 1 an diesem unlösbar fixiert wurden, angeordnet. Selbstverständlich können zur Vermeidung von Schäden, beispielsweise infolge von Erschütterungen oder großen Temperaturschwankungen, im Motorraum Schutzmaßnahmen wie partielles Ausschäumen der Anschlußvorrichtung 1 mit beispielsweise PU-Schaum, Einbringen von Silikonpäcken, Thermoisolieren oder dergleichen getroffen werden.

Fig. 2 zeigt eine Draufsicht auf ein modulares Trägerelement, wobei die einzelnen Module 2',2",2"' mechanisch und elektrisch verbunden sind. Die Module 2' und 2" bilden einen geraden Stoß 9, wobei die elektrische und die mechanische Verbindung zwischen diesen beiden Modulen 2', 2" des Trägerelementes 2 mittels Drahtverbindern 10 hergestellt ist. Hingegen sind die Module 2" und 2'" mechanisch über einen formschlüssigen Stoßes 8 verbunden und weisen zur elektrischen Verbindung Steckverbinder 11 auf. Natürlich sind auch andere geeignete Verbindungsvarianten und -möglichkeiten denkbar. Auf dem Modul 2" sind schematisch dargestellt ein unlösbar fixierter Bauteil 7 und eine Steckvorrichtung 12, in die - nach dem Einbringen des Trägerelementes 2 in die Anschlußvorrichtung 1 - ein weiterer Bauteil 7 durch eine Aufnahmeöffnung 16 der Anschlußvorrichtung 1 lösbar einbringbar ist.

In Fig. 3 ist ersichtlich, daß sich an der Unterseite der Module 2',2",2"', vorzugsweise Platinen, Leiterbahnen 3' befinden. Diese können natürlich abschnittweise auch quer zur Kanallängsrichtung verlaufen.

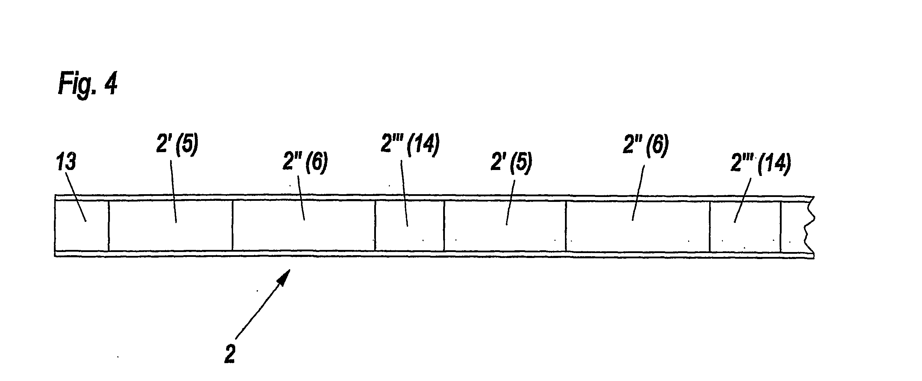

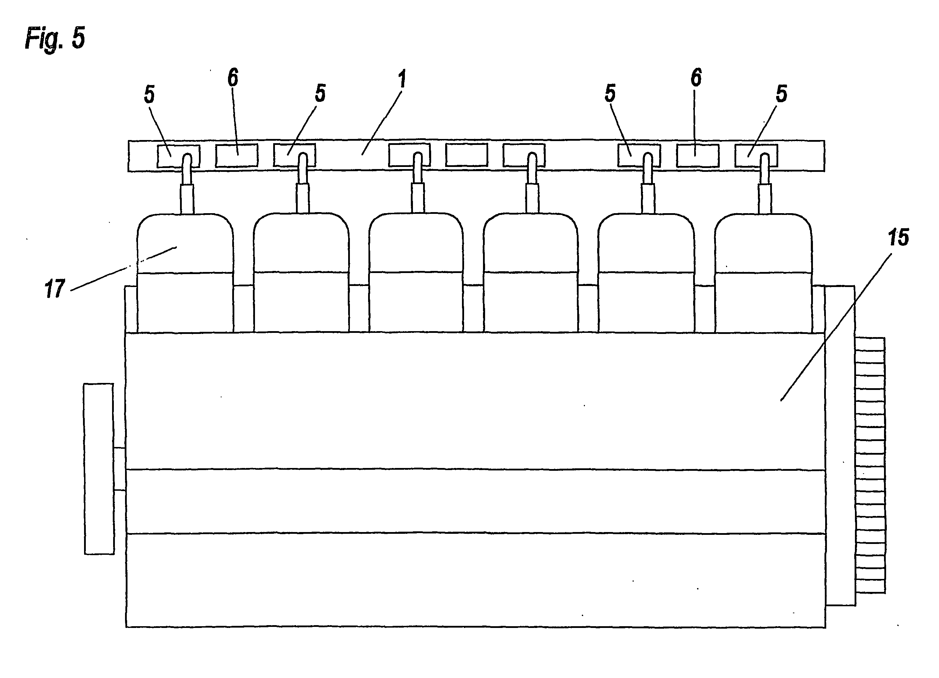

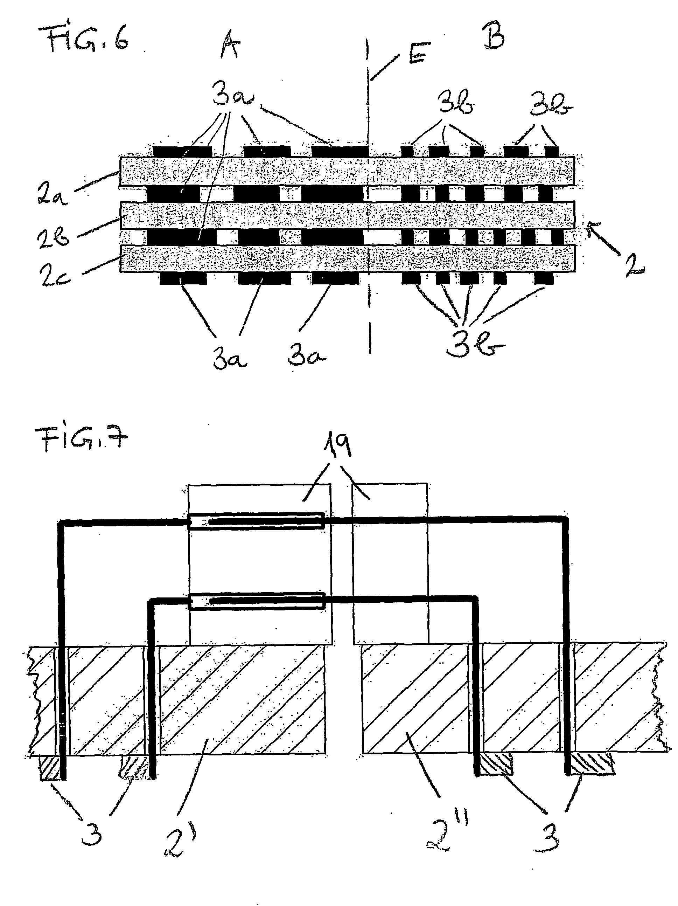

Fig. 4 zeigt den schematischen Aufbau eines modularen Trägerelementes 2. Das Endstück 13 des Trägerelementes 2 weist nur Leitungen auf. Das Modul 2' (5) ist der Zündspule 5, das Modul 2" (6) einem Sensor-/Aktormodul zugeordnet, wobei die Art der Anbringung - vormontierte oder einzubringenden Bauteile 5,6 (nicht dargestellt) - beliebig wählbar ist. Diese Module 2', 2" weisen Leitungen 3 (nicht dargestellt) und Bauteile 5, 6 bzw. Stechvorrichtungen 12 zur lösbaren Anbringung von Bauteilen 5, 6 auf. Das Modul 2"'(14) stellt lediglich ein Verbindungsmodul dar und weist ebenfalls nur Leitungen 3 auf. Selbstverständlich kann dieses Ausführungsbeispiel nur als eine von vielen möglichen Kombinationen von Modulen gesehen werden. Wenn auch bevorzugt vorgesehen ist, daß die Zündschaltung zum Ansteuern der Zündspule am Trägerelement 2 angeordnet ist, kann die Ansteuerung der Zündspule auch extern erfolgen. Ist das modulare Trägerelement 2,- vorzugsweise ein modularer Platinenzug, fertiggestellt, wird er in einfacher Weise in die kanalförmige Anschlußvorrichtung 1 eingeschoben.

Fig. 5 zeigt einen Verbrennungsmotor 15 mit Zylindern 17, die jeweils über eine Zündspule 5 mit dem Trägerelement 2 (nicht dargestellt) verbunden sind. Zwischen je zwei Zündspulen 5 ist ein Meßmodul 6 angeordnet, wobei die Zündspule 5 und das Meßmodul 6 durch Aufnahmeöffnungen in die Anschlußvorrichtung eingebracht wurden.

Die Fig. 6 zeigt ein bevorzugtes Ausführungsbeispiel für das Trägerelement 2, welches mehrere Lagen bzw. Schichten 2a, 2b und 2c aus elektrisch isolierendem Material aufweist. Die Leiterbahnen 3a und 3b sind bei diesem Ausführungsbeispiel auf, unter und zwischen den isolierenden Schichten der Platine angeordnet.

Dabei sind zur Vermeidung von Störungen die elektrischen Zündleitungen 3a, die Zündsignale für die Zündspulen liefern einerseits und die Signalleitungen 3b andererseits, welche Meßsignale von am Verbrennungsmotor angeordneten Sensoren übertragen können in räumlich getrennten Bereichen A bzw. B am Trägerelement 2 angeordnet. Beim dargestellten Ausführungsbeispiel sind diese räumlich getrennten Bereiche A und B links und rechts einer Längsmittelebene E angeordnet. Dies ist besonders dann günstig, wenn die Zündleitungen 3a als Hochspannungsleitungen mit Spannungen vorzugsweise über 100V ausgeführt sind, die die Zündspulen 5 direkt speisen. Durch diese Links-Rechts-Trennung können dann diese Zündleitungen trotz der geführten Hochspannungen die auf den Signalleitungen 3b geführten Meßsignale nicht stören.

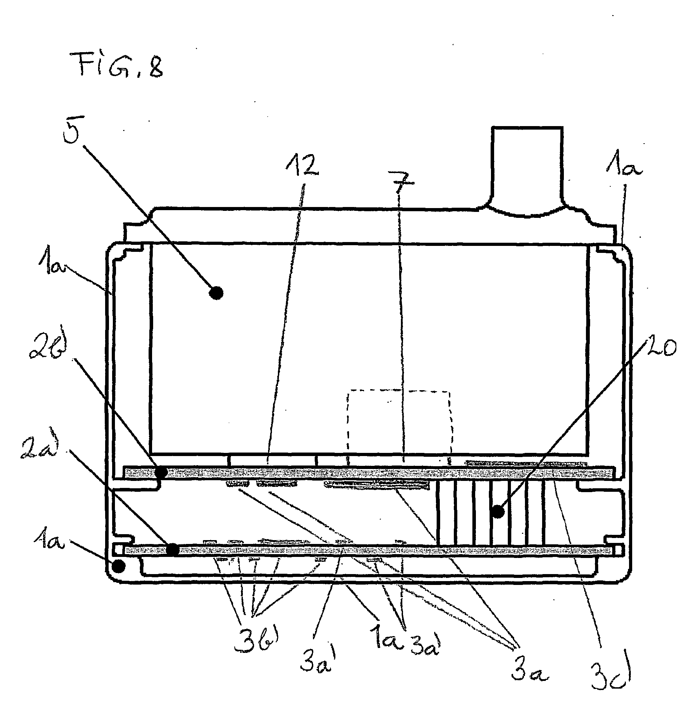

Die Fig. 7 zeigt ein Ausführungsbeispiel mit einer elektrischen Steckverbindung 19 zwischen den Modulen 2' und 2". Auf diese Art und Weise können die Platinen 2' bzw. 2" auf einfache Weise elektrisch miteinander verbunden werden, wobei über die Steckverbindung sogar ein zusätzlicher mechanischer Halt in lösbarer Weise gegeben ist. Insgesamt läßt sich über solche Steckverbindungen 19 ein ganzer Platinenzug herstellen, der dann in axialer Längsrichtung in den im wesentlichen geschlossenen Kanal einschiebbar ist. Bevorzugt ist nämlich vorgesehen, daß die kanalförmige Anschlußvorrichtung eine im Querschnitt einstückige - gegebenenfalls bis auf diskret verteilte Öffnungen 16 - geschlossene Kanalwand 1 a aufweist, die sich in Kanallängsrichtung durchgehend vorzugsweise über mindestens zwei Zylinder des Verbrennungsmotors erstreckt. Mit dieser Konstruktion läßt sich eine robuste und störunempfindliche Bauweise erzielen. Wenn der Kanal im wesentlichen einstückig geschlossen ist, wie dies beim bevorzugten Ausführungsbeispiel der Fall ist, wird man das Trägerelement 2 bzw. den aus mehreren hintereinandergeschalteten Modulen gebildeten "Zug" in axialer Längsrichtung in den Kanal einschieben.

Die Fig. 8 zeigt ein alternatives Ausführungsbeispiel zur Fig. 1, wobei hier zwei gesonderte, übereinanderliegende Trägerelemente 2a' und 2b' vorgesehen sind. Das untere Trägerelement 2a' trägt Signalleitungen bzw. Meßleitungen 3b' in Form von Leiterbahnen sowie - ebenfalls in Form von Leiterbahnen - Zündsteuerleitungen 3a'. Diese Zündsteuerleitungen 3a' führen keine Hochspannung sondern im wesentlichen nur die Information, wann welcher Zylinder zünden soll. Die eigentliche Hochspannung für die Zündspulen 5' wird über eine breite Leiterbahn (Hochspannungsleitung 3c') auf der oberen Platine 2b' geführt. Die obere und untere Platine sind über einen Platinenstecker 20 miteinander verbunden. Bei diesem Ausführungsbeispiel können die Zündsteuerleitungen 3a' und die Signalleitungen 3b' ohne weiteres in räumlicher Nähe verlaufen, da auf den Zündsteuerleitungen 3a' keine störenden Hochspannungen geführt werden.

Die eigentlichen Zündspannungen werden von einer elektronischen Zündschaltung 7 auf der Platine 2b' gebildet, und zwar in Abhängigkeit von den auf den Zündsteuerleitungen 3a' über die Steckverbindung 20 zugeführten Signalen, und unter Verwendung der Hochspannung auf der Leitung 3c`. Die so gebildeten eigentlichen Zündsignale gelangen dann über die Zündleitungen 3a und den Stecker 12 in die Zündspule 5. Selbstverständlich sind auch hier die Leiterbahnen nur schematisch dargestellt. Sie können auch quer zur Kanallängsrichtung und gegebenenfalls in mehreren Schichten verlaufen.

## Patentansprüche

1. Kanalförmige Anschlussvorrichtung für elektrische Leitungen, insbesondere Signal- und Zündleitungen, von Verbrennungsmotoren, wobei mindestens ein Trägerelement (2) für - insbesondere vormontierte - elektrische Leitungen (3) und Bauteile (7) vorgesehen ist, welches in Aufnahmen (4) der kanalförmigen Anschlußvorrichtung (1) einbringbar ist, **dadurch gekennzeichnet, dass** das Trägerelement (2) zumindest teilweise einen modularen Aufbau aufweist und mehrere in Längsrichtung der kanalförmigen Anschlussvorrichtung hintereinandergeschaltete Module (2',2",2"') des Trägerelementes (2) in der Weise elektrisen und mechanisch, vorzugsweise mechanisen lösbar, miteinander verbunden sind, dass sie einen, in Längsrichtung, in die kanalförmige Anschlussvorrichtung einbringbaren Modulzug bilden.

2. Kanalförmige Anschlussvorrichtung nach Anspruch 1, **dadurch gekennzeichnet, dass** die Module (2', 2", 2"') des Trägerelementes (2) in der Weise mechanisch miteinander verbunden sind, dass der aus ihnen gebildete Modulzug in eine im Wesentlichen geschlossen ausgebildete kanalförmige Anschlussvorrichtung einschiebbar bzw. einziehbar ist.

3. Kanalförmige Anschlussvorrichtung nach Anspruch 1 oder 2, **dadurch gekennzeichnet, dass** die mechanische Verbindung zwischen den Modulen (2', 2", 2"') des Trägerelementes (2) mittels Drahtverbindern (10) oder über einen formschlüssigen Stoß (8) oder über elektrische Steckverbindungen (11, 19) hergestellt ist.

4. Kanalförmige Anschlussvorrichtung nach einem der Ansprüche 1 bis 3, **dadurch gekennzeichnet, dass** die elektrischen Leitungen (3) und die Bauteile (7) auf zwei gegenüberliegenden Seiten des Trägerelementes (2) angeordnet sind.

5. Kanalförmige Anschlussvorrichtung nach einem der Ansprüche 1 bis 4, **dadurch gekennzeichnet, dass** die elektrischen Leitungen (3) als Leiterbahnen (3') und/oder Kabel ausgebildet sind.

6. Kanalförmige Anschlussvorrichtung nach einem der Ansprüche 1 bis 5, **dadurch gekennzeichnet, dass** das Trägerelement (2) plattenförmig, vorzugsweise in Form einer Platine, ausgebildet ist.

7. Kanalförmige Anschlussvorrichtung nach einem der Ansprüche 1 bis 6, **dadurch gekennzeichnet, dass** das Trägerelement (2) mehrere Lagen (2a, 2b, 2c) aufweist und vorzugsweise als mehrschichtige Platine ausgebildet ist.

8. Kanalförmige Anschlussvorrichtung nach Anspruch 7, **dadurch gekennzeichnet, dass** die Leiterbahnen (3a, 3b) auf, unter und/oder zwischen den isolierenden Schichten (2a, 2b, 2c) der Platine angeordnet sind.

9. Kanalförmige Anschlussvorrichtung nach einem der Ansprüche 1 bis 8, **dadurch gekennzeichnet, dass** sie sowohl Zündleitungen (3a) als auch Signalleitungen (3b) aufweist und die elektrischen Zündleitungen (3a), die Zündsignale für die Zündspulen liefern, einerseits und die Signalleitungen (3b) andererseits, welche vorzugsweise Meßsignale von am Verbrennungsmotor angeordneten Sensoren übertragen, in räumlich getrennten - vorzugsweise im wesentlichen links und rechts einer Längsmittelebene (E) des Trägerelementes (2) liegenden - Bereichen (A,B) am Trägerelement (2) angeordnet sind (Fig. 5).

10. Kanalförmige Anschlussvorrichtung nach einem der Ansprüche 1 bis 9, **dadurch gekennzeichnet, dass** sie Zündleitungen (3a) aufweist und diese als Hochspannungsleitungen mit Spannungen vorzugsweise über 100V ausgeführt sind und direkt die Zündspulen (5) speisen (Fig. 1).

11. Kanalförmige Anschlussvorrichtung nach einem der Ansprüche 1 bis 10, **dadurch gekennzeichnet, dass** sie Zündleitungen aufweist und diese als Zündsteuerleitungen (3a') ausgeführt sind und mindestens eine Hochspannungsleitung (3c') an einem Trägerelement (2b') angeordnet ist, wobei jeder Zündspule (5) eine auf einem Trägerelement (2b') angeordnete elektronische Zündschaltung (7) zugeordnet ist, die in Abhängigkeit von den auf den Zündsteuerleitungen (3a') anliegenden Signalen und der Spannung auf der Hochspannungsleitung (3c') ein der jeweiligen Zündspule (5) zugeführtes Zündsignal bereitstellt (Fig. 8).

12. Kanalförmige Anschlussvorrichtung nach Anspruch 10 und 11, **dadurch gekennzeichnet, dass** die Zündsteuerleitungen (3a') und Signalleitungen (3b') auf einem anderen Trägerelement (2a') angeordnet sind als die Hochspannungsleitung (3c') am Trägerelement (2b').

13. Kanalförmige Anschlussvorrichtung nach einem der Ansprüche 1 bis 12, **dadurch gekennzeichnet, dass** in die kanalförmige Anschlußvorrichtung zumindest zwei gesonderte, vorzugsweise übereinander liegende Trägerelemente (2a', 2b') eingebracht, vorzugsweise eingeschoben sind.

14. Kanalförmige Anschlussvorrichtung nach einem der Ansprüche 1 bis 13, **dadurch gekennzeichnet, dass** die einzelnen in Längsrichtung der kanalförmigen Anschlussvorrichtung hintereinandergereihten Module (2', 2", 2"') des Trägerelementes (2) elektrisch - vorzugsweise lösbar - miteinander verbunden sind.

15. Kanalförmige Anschlussvorrichtung nach Anspruch 14, **dadurch gekennzeichnet, dass** zwischen den Modulen (2', 2") eine elektrische Steckverbindung (19) im Bereich der Stirnseiten der Module vorgesehen ist.

16. Kanalförmige Anschlussvorrichtung nach einem der Ansprüche 1 bis 15, **dadurch gekennzeichnet, dass** jedem Modul (2',2",2"') des Trägerelementes (2) ein Zylinder (17) des Verbrennungsmotors (15) zugeordnet ist.

17. Kanalförmige Anschlussvorrichtung nach einem der Ansprüche 1 bis 15, **dadurch gekennzeichnet, dass** jedem Modul (2',2',2"') des Trägerelementes (2) mehrere, vorzugsweise zwei Zylinder (17) des Verbrennungsmotors (15) zugeordnet sind.

18. Kanalförmige Anschlussvorrichtung nach einem der Ansprüche 1 bis 17, **dadurch gekennzeichnet, dass** die Bauteile (7) eine Zündspule (5) und/oder Sensor- und/oder Aktormodule (6) umfassen.

19. Kanalförmige Anschlussvorrichtung nach einem der Ansprüche 1 bis 18, **dadurch gekennzeichnet, dass** die Bauteile (7) die Zündschaltung zur Ansteuerung der Zündspule (5) umfassen.

20. Kanalförmige Anschlussvorrichtung nach einem der Ansprüche 1 bis 19, **dadurch gekennzeichnet, dass** zumindest ein Teil der Bauteile (7) vor dem Einbringen des Trägerelementes (2) in die Anschlußvorrichtung (1) an jenem unlösbar fixiert sind.

21. Kanalförmige Anschlussvorrichtung nach einem der Ansprüche 1 bis 20, **dadurch gekennzeichnet, dass** zumindest ein Teil der Bauteile (7) lösbar am Trägerelement (2) angeordnet ist.

22. Kanalförmige Anschlussvorrichtung nach Anspruch 21, **dadurch gekennzeichnet, dass** zur lösbaren Halterung der Bauteile (7) Steckvorrichtungen (12) vorgesehen sind.

23. Kanalförmige Anschlußvorrichtung nach einem der Ansprüche 1 bis 22, **dadurch gekennzeichnet, dass** die Anschlussvorrichtung (1) Aufnahmeöffnungen (16) für die lösbar anzuordnenden Bauteile (7) aufweist, welche durch diese Aufnahmeöffnungen (16) hindurch von außen in die Anschlußvorrichtung (1) einsetzbar und mit dem Trägerelement (2) verbindbar sind.

24. Kanalförmige Anschlussvorrichtung nach einem der Ansprüche 1 bis 23, **dadurch gekennzeichnet, dass** die Anschlussvorrichtung (1) für jedes Bauteil (7) eine eigene Aufnahmeöffnung (16) aufweist.

25. Kanalförmige Anschlussvorrichtung nach einem der Ansprüche 1 bis 24, **dadurch gekennzeichnet, dass** die Anschlussvorrichtung (1) eine Sicke (18) zur Aufnahme zusätzlicher Kabel aufweist.

26. Kanalförmige Anschlussvorrichtung nach einem der Ansprüche 1 bis 25, **dadurch gekennzeichnet, dass** sie eine im Querschnitt einstückige - gegebenenfalls bis auf diskret verteilte Öffnungen (16) - geschlossene Kanalwand (1a) aufweist, die sich in Kanallängsrichtung durchgehend vorzugsweise über mindestens zwei Zylinder des Verbrennungsmotors erstreckt.

27. Kanalförmige Anschlussvorrichtung nach einem der Ansprüche 1 bis 26, **dadurch gekennzeichnet, dass** die Anschlussvorrichtung (1) aus Aluminium hergestellt ist.

28. Kanalförmige Anschlussvorrichtung nach einem der Ansprüche 1 bis 27, **dadurch gekennzeichnet, dass** die Anschlussvorrichtung (1) zumindest, beispielsweise mit PU-Schaum, ausgeschäumt ist.

## Claims

1. A channel-shaped connecting device for electric lines, in particular signal and ignition lines, of internal combustion engines, wherein at least one carrier element (2) for - in particular pre-assembled - electric lines (3) and components (7) is provided, which can be inserted into receiving means (4) of the channel-shaped connecting device (1), **characterised in that** the carrier element (2) comprises at least partially a modular structure and several modules (2', 2", 2"') of the carrier element (2), which are connected in series in a row succession in the longitudinal direction of the channel-shaped connection device, are electrically and mechanically, preferably mechanically releasably, connected together so that they build a module string which can be inserted in the longitudinal direction into the channel-shaped connecting device.

2. A channel-shaped connecting device as set forth in claim 1, **characterised in that** the modules (2', 2", 2"') of the carrier element (2) are mechanically connected together in a way that the module string built by them can be pushed or pulled, respectively, into a channel-shaped connecting device, which is of an essentially closed structure.

3. A channel-shaped connecting device as set forth in claim 1 or 2, **characterised in that** the mechanical connection between the modules (2', 2", 2"') of the carrier element (2) is established by means of wire connectors (10) or via a form-closed face (8) or via electric plug connections (11, 19).

4. A channel-shaped connecting device as set forth in one of claims 1 to 3, **characterised in that** the electric lines (3) and the components (7) are arranged on two mutually opposite sides of the carrier element (2).

5. A channel-shaped connecting device as set forth in one of claims 1 to 4, **characterised in that** the electric lines (3) are in form of conductor tracks (3') and/or cables.

6. A channel-shaped connecting device as set forth in one of claims 1 to 5, **characterised in that** the carrier element (2) is of a plate-shaped configuration, preferably in the form of a circuit board.

7. A channel-shaped connecting device as set forth in one of claims 1 to 6, **characterised in that** the carrier element (2) has several layers (2a, 2b, 2c) and is preferably in the form of a multi-layer circuit board.

8. A channel-shaped connecting device as set forth in claim 7, **characterised in that** the conductor tracks (3a, 3b) are arranged on, under and/or between the insulating layers (2a, 2b, 2c) of the circuit board.

9. A channel-shaped connecting device as set forth in one of claims 1 to 8, **characterised in that** it has ignition lines (3a) as well as signal lines (3b) and the electric ignition lines (3a) which supply ignition signals for the ignition coils, on the one hand, and the signal lines (3b), on the other hand, which preferably transmit measurement signals from sensors arranged on the internal combustion engine, are arranged on the carrier element (2) in spatially separate regions - preferably substantially to the left and the right of a longitudinal central plane (E) of the carrier element (2) - (Fig. 1).

10. A channel-shaped connecting device as set forth in one of claims 1 to 9, **characterised in that** it has ignition lines (3a), which are in the form of high-voltage lines involving voltages of preferably over 100 V and directly feed the ignition coils (5) (Fig. 5).

11. A channel-shaped connecting device as set forth in one of claims 1 to 10, **characterised in that** it has ignition lines (3a), which are in the form of ignition control lines (3a'), and at least one high-voltage line (3c') is arranged on a carrier element (2b'), wherein associated with each ignition coil (5) is an electronic ignition circuit (7) which is arranged on a carrier element (2b') and which in dependence on the signals on the ignition control lines (3a') and the voltage on the high-voltage line (3c') produces an ignition signal which is fed to the respective ignition coil (5) (Fig. 8).

12. A channel-shaped connecting device as set forth in claim 10 or 11, **characterised in that** the ignition control lines (3a') and signal lines (3b') are arranged on a carrier element (2a') other than high-voltage line (3c') on the carrier element (2b').

13. A channel-shaped connecting device as set forth in one of claims 1 to 12, **characterised in that** at least two separate, preferably mutually superimposed carrier elements (2a', 2b') are introduced, preferably pushed, into the channel-shaped connecting device.

14. A channel-shaped connecting device as set forth in one of claims 1 to 13, **characterised in that** the individual modules (2', 2", 2"') of the carrier element (2), which are arranged in a row in succession in the longitudinal direction of the channel-shaped connecting device, are electrically - preferably releasably - connected together.

15. A channel-shaped connecting device as set forth in claim 14, **characterised in that** an electrical plug connection (19) is provided between the modules (2', 2") in the region of the front ends of the modules.

16. A channel-shaped connecting device as set forth in one of claims 1 to 15, **characterised in that** a cylinder (17) of the internal combustion engine (15) is associated with each module (2', 2", 2"') of the carrier element (2).

17. A channel-shaped connecting device as set forth in one of claims 1 to 15, **characterised in that** a plurality of, preferably two, cylinders (17) of the internal combustion engine (15) is associated with each module (2', 2", 2"') of the carrier element (2).

18. A channel-shaped connecting device as set forth in one of claims 1 to 17, **characterised in that** the components (7) include an ignition coil (5) and/or sensor and/or actuator modules (6).

19. A channel-shaped connecting device as set forth in one of claims 1 to 18, **characterised in that** the components (7) include the ignition circuit for operation of the ignition coil (5).

20. A channel-shaped connecting device as set forth in one of claims 1 to 19, **characterised in that** at least a part of the components (7) are non-releasably fixed to the carrier element (2) before the carrier element is introduced into the connecting device (1).

21. A channel-shaped connecting device as set forth in one of claims 1 to 20, **characterised in that** at least a part of the components (7) are releasably fixed to the carrier element (2).

22. A channel-shaped connecting device as set forth in claim 21, **characterised in that** plug devices (12) are provided for releasably holding the components (7).

23. A channel-shaped connecting device as set forth in one of claims 1 to 22, **characterised in that** the connecting device (1) has receiving openings (16) for the components (7) which are to be releasably arranged and which can be inserted through said receiving openings (16) from the exterior into the connecting device (1) and connected together to the carrier element (2).

24. A channel-shaped connecting device as set forth in one of claims 1 to 23, **characterised in that** the connecting device (1) has for each component (7) its own receiving opening (16).

25. A channel-shaped connecting device as set forth in one of claims 1 to 24, **characterised in that** the connecting device (1) has a recess (18) for receiving additional cables.

26. A channel-shaped connecting device as set forth in one of claims 1 to 25, **characterised in that** it has channel wall (1a) which is in one piece in cross-section and which is closed - possibly except for discreetly distributed openings (16) - and which extends continuously in the longitudinal direction of the channel, preferably over at least two cylinders of the internal combustion engine.

27. A channel-shaped connecting device as set forth in one of claims 1 to 26, **characterised in that** the connecting device (1) is made from aluminium.

28. A channel-shaped connecting device as set forth in one of claims 1 to 27, **characterised in that** the connecting device (1) is at least foam-filled, for example with PU foam.

## Revendications

1. Dispositif de raccordement en forme de goulotte destiné à des câbles électriques, en particulier des câbles de signalisation et d'allumage, de moteurs à combustion interne, dans lequel il est prévu au moins un élément de support (2) pour des lignes électriques (3) et des composants (7) - notamment préassemblés -, qui peut être introduit dans des logements (4) du dispositif de raccordement en forme de goulotte (1), **caractérisé en ce que** l'élément de support (2) comprend au moins partiellement une structure modulaire et plusieurs modules (2', 2", 2'") de l'élément de support (2), raccordés en série l'un après l'autre dans la direction longitudinale du dispositif de raccordement en forme de goulotte, sont raccordés électriquement et mécaniquement l'un à l'autre, de préférence de façon séparable mécaniquement, de telle manière qu'ils forment un train de modules pouvant être introduit en direction longitudinale dans le dispositif de raccordement en forme de goulotte.

2. Dispositif de raccordement en forme de goulotte selon la revendication 1, **caractérisé en ce que** les modules (2', 2", 2"') de l'élément de support (2) sont assemblés mécaniquement l'un à l'autre de telle manière que le train de modules qu'ils forment puisse être poussé, respectivement tiré dans un dispositif de raccordement en forme de goulotte essentiellement fermé.

3. Dispositif de raccordement en forme de goulotte selon la revendication 1 ou 2, **caractérisé en ce que** l'assemblage mécanique entre les modules (2', 2", 2' ") de l'élément de support (2) est réalisé par des liens en fil (10) ou par un joint à emboîtement (8) ou par des connexions électriques à fiches (11, 19).

4. Dispositif de raccordement en forme de goulotte selon l'une quelconque des revendications 1 à 3, **caractérisé en ce que** les lignes électriques (3) et les composants (7) sont disposés sur deux côtés opposés de l'élément de support (2).

5. Dispositif de raccordement en forme de goulotte selon l'une quelconque des revendications 1 à 4, **caractérisé en ce que** les lignes électriques (3) sont réalisées sous forme de voies conductrices (3') et/ou de câbles.

6. Dispositif de raccordement en forme de goulotte selon l'une quelconque des revendications 1 à 5, **caractérisé en ce que** l'élément de support (2) est réalisé en forme de plaque, de préférence en forme de platine.

7. Dispositif de raccordement en forme de goulotte selon l'une quelconque des revendications 1 à 6, **caractérisé en ce que** l'élément de support (2) comprend plusieurs couches (2a, 2b, 2c) et est réalisé de préférence sous forme de platine multicouche.

8. Dispositif de raccordement en forme de goulotte selon la revendication 7, **caractérisé en ce que** les voies conductrices (3a, 3b) sont disposées sur, en dessous et/ou entre les couches isolantes (2a, 2b, 2c) de la platine.

9. Dispositif de raccordement en forme de goulotte selon l'une quelconque des revendications 1 à 8, **caractérisé en ce qu'**il comprend aussi bien des lignes d'allumage (3a) que des lignes de signalisation (3b) et les lignes électriques d'allumage (3a), qui fournissent des signaux d'allumage aux bobines d'allumage, d'une part et les lignes de signalisation (2b) d'autre part, qui transmettent de préférence des signaux de mesure de capteurs disposés sur le moteur à combustion interne, sont disposées sur l'élément de support (2), dans des régions (A, B) spatialement séparées - situées de préférence essentiellement à gauche et à droite d'un plan médian longitudinal (E) de l'élément de support (2) (Fig. 5).

10. Dispositif de raccordement en forme de goulotte selon l'une quelconque des revendications 1 à 9, **caractérisé en ce qu'**il comprend des lignes d'allumage (3a) et celles-ci sont réalisées sous forme de lignes à haute tension avec des tensions de préférence supérieures à 100 V et alimentent directement les bobines d'allumage (5) (Fig. 1).

11. Dispositif de raccordement en forme de goulotte selon l'une quelconque des revendications 1 à 10, **caractérisé en ce qu'**il comprend des lignes d'allumage et celles-ci sont réalisées sous forme de lignes de commande d'allumage (3a') et au moins une ligne à haute tension (3c') est disposée sur un élément de support (2b'), dans lequel, à chaque bobine d'allumage (5) est associé un circuit d'allumage électronique (7) disposé sur un élément de support (2b'), qui produit un signal d'allumage envoyé à la bobine d'allumage respective (5) en fonction des signaux présents sur les lignes de commande d'allumage (3a') et de la tension sur la ligne à haute tension (3c') (Fig. 8).

12. Dispositif de raccordement en forme de goulotte selon la revendication 10 et 11, **caractérisé en ce que** les lignes de commande d'allumage (3a') et les lignes de signalisation (3b') sont disposées sur un autre élément de support (2a') que la ligne à haute tension (3c') sur l'élément de support (2b').

13. Dispositif de raccordement en forme de goulotte selon l'une quelconque des revendications 1 à 12, **caractérisé en ce qu'**au moins deux éléments de support séparés (2a', 2b'), de préférence superposés, sont introduits, de préférence glissés, dans le dispositif de raccordement en forme de goulotte.

14. Dispositif de raccordement en forme de goulotte selon l'une quelconque des revendications 1 à 13, **caractérisé en ce que** les modules individuels (2', 2", 2"') de l'élément de support (2), montés en série l'un derrière l'autre en direction longitudinale du dispositif de raccordement en forme de goulotte, sont raccordés électriquement l'un à l'autre - de préférence de façon séparable.

15. Dispositif de raccordement en forme de goulotte selon la revendication 14, **caractérisé en ce qu'**il est prévu une connexion électrique à fiches (19) entre les modules dans la région des faces frontales des modules.

16. Dispositif de raccordement en forme de goulotte selon l'une quelconque des revendications 1 à 15, **caractérisé en ce qu'**un cylindre (17) du moteur à combustion interne (15) est associé à chaque module (2', 2", 2"') de l'élément de support (2).

17. Dispositif de raccordement en forme de goulotte selon l'une quelconque des revendications 1 à 15, **caractérisé en ce que** plusieurs, de préférence deux cylindres (17) du moteur à combustion interne (15) sont associés à chaque cylindre (2', 2", 2 "') de l'élément de support (2).

18. Dispositif de raccordement en forme de goulotte selon l'une quelconque des revendications 1 à 17, **caractérisé en ce que** les composants (7) comprennent une bobine d'allumage (5) et/ou des modules de capteur et/ou des modules d'actionneur (6).

19. Dispositif de raccordement en forme de goulotte selon l'une quelconque des revendications 1 à 18, **caractérisé en ce que** les composants (7) comprennent le circuit d'allumage pour la commande de la bobine d'allumage (5).

20. Dispositif de raccordement en forme de goulotte selon l'une quelconque des revendications 1 à 19, **caractérisé en ce qu'**au moins une partie des composants (7) sont fixés de façon inséparable dans le dispositif de raccordement en forme de goulotte avant l'introduction de l'élément de support (2) dans celui-ci.

21. Dispositif de raccordement en forme de goulotte selon l'une quelconque des revendications 1 à 20, **caractérisé en ce qu'**au moins une partie des composants (7) sont disposés de façon séparable sur l'élément de support (2).

22. Dispositif de raccordement en forme de goulotte selon la revendication 21, **caractérisé en ce qu'**il est prévu des connexions à fiches (12) pour le montage séparable des composants (7).

23. Dispositif de raccordement en forme de goulotte selon l'une quelconque des revendications 1 à 22, **caractérisé en ce que** le dispositif de raccordement (1) comporte des ouvertures de réception (16) pour les composants (7) à disposer de façon séparable, qui peuvent être introduits dans le dispositif de raccordement (1) et être assemblés à l'élément de support (2) de l'extérieur à travers ces ouvertures de réception (16).

24. Dispositif de raccordement en forme de goulotte selon l'une quelconque des revendications 1 à 23, **caractérisé en ce que** le dispositif de raccordement (1) comporte une ouverture de réception particulière (16) pour chaque composant (7).

25. Dispositif de raccordement en forme de goulotte selon l'une quelconque des revendications 1 à 24, **caractérisé en ce que** le dispositif de raccordement (1) présente une moulure (18) destinée à recevoir des câbles supplémentaires.

26. Dispositif de raccordement en forme de goulotte selon l'une quelconque des revendications 1 à 25, **caractérisé en ce qu'**il présente une paroi de goulotte d'une seule pièce fermée en section transversale (1a) - éventuellement jusqu'à des ouvertures (16) réparties de façon discrète -, qui s'étend dans la direction longitudinale de la goulotte de façon continue de préférence sur au moins deux cylindres du moteur à combustion interne.

27. Dispositif de raccordement en forme de goulotte selon l'une quelconque des revendications 1 à 26, **caractérisé en ce que** le dispositif de raccordement (1) est fabriqué en aluminium.

28. Dispositif de raccordement en forme de goulotte selon l'une quelconque des revendications 1 à 27, **caractérisé en ce que** le dispositif de raccordement (1) est rempli de mousse, par exemple de mousse de polyuréthane.
